# EUROPÄISCHE PATENTSCHRIFT

(11) **EP 1 569 002 B1**
(45) Veröffentlichungstag und Bekanntmachung des Hinweises auf die Patenterteilung: **26.07.2006**
(21) Anmeldenummer: 05002754.9
(22) Anmeldetag: 10.02.2005
(51) Int. Cl.: G01R 11/04

(54) **Stromzähleranordnung**
Electricity Meter System
Système d'un compteur d'électricité

(30) Priorität: 27.02.2004 DE 102004010139
(43) Veröffentlichungstag der Anmeldung: 31.08.2005
(73) Patentinhaber: ABB PATENT GmbH, 68526 Ladenburg (DE)
(72) Erfinder: Eppe, Klaus-Peter, Dipl.-Ing., 69429 Waldbrunn (DE); Wieland, Ralf, Dipl.Ing. (FH), 69429 Waldbrunn (DE)
(74) Vertreter: Miller, Toivo

(56) Entgegenhaltungen:
- EP-A- 1 431 765
- EP-A- 1 462 808
- DE-A1- 10 052 998
- DE-U1- 20 313 421
- DE-U1- 20 313 847
- DE-U1-7202004 006 07

## Beschreibung

Die Erfindung betrifft eine Stromzähleranordnung.

In DE 203 13 421 U ist eine Stronzählenanordnung beschrieben, bei der ein Elektrizitätszähler steck- und verschiebbar auf einer Zählertragplatte angeordnet ist. Dieser Elektrizitätszähler ist mit Einhängewinkelstücken bestickt, die die Einhängeschlitze an der Zählertragplatte hintergreifen, wobei die elektrische Verbindung des Elektrizitätszählers zwischen dem Versorgungsnetz und der Kundenanlage über am Elektrizitätszähler angeordneten Steckverbindungsteile, die die Zählertragplatte durchdringen und die hinter der Zählertragplatte angeordneten Komplementären Steckverbindungsteile Kontaktieren, hergestellt wird.

Eine weitere Stromzähleranordnung ist in der nicht vorveröffentlichten Schrift DE 10 2004 003 050.2 vom 20.01.2004 (EP 1 557 677 A) beschrieben. Diese Stromzähleranordnung besitzt einen Adapter, der auf einem Zählerkreuz in einem Zählerplatz befestigt und auf den ein elektrischer Stromzähler aufgesetzt werden. Dieser elektronische Stromzähler besitzt an seiner Befestigungsseite eine der Anzahl der Phasen entsprechende Anzahl von Anschlusssteckerstiften, die als Flachstecker oder Anschlussfahnen ausgebildet sein können, über die der Strom pro Phase zum Zähler hin und vom Zähler abgeleitet wird. Diese Anschlusssteckerstifte greifen im montierten Zustand des Stromzählers in feststehende, als Tulpen ausgebildete Kontaktstücke ein, von denen jeweils eines jeder Phase mit einem Zugangsleiter und das andere jeder Phase mit dem zugehörigen Abgangsieiter zum Verbraucher verbunden sind. Damit beim Auswechseln eines Stromzählers der Stromfluss zum Verbraucher nicht unterbrochen wird, befindet sich innerhalb des Adapters jeweils eine Kontaktbrücke pro Phase, die im montierten Zustand des Stromzählers frei von den Kontaktstücken ist, so dass der Strom ausschließlich über den Stromzähler fließt. Jeweils eines der Anschlusskontaktstifte am Stromzähler ist formschlüssig mit der zugehörigen Kontaktbrücke verbunden, so dass beim Demontieren des Stromzählers die Kontaktbrücke verschoben wird, derart, dass, bevor die Anschlusskontaktstifte des Stromzählers frei von den feststehenden Kontaktstücken gelangen, die Kontaktbrücke ein Kurzschließen der zugehörigen Kontaktstücke bewirkt, so dass auf diese Weise bei der Demontage eine Stromunterbrechung zum Verbraucher vermieden ist. Der Montagevorgang erfolgt umgekehrt: Durch die Montage werden die Kontaktbrücken verschoben, wobei eine Kontaktierung zunächst der Anschlusskontaktstifte mit den feststehenden Kontaktstücken erzeugt wird, so dass bei der Montage während eines bestimmten Zeitraumes ein Stromfluss sowohl über die Kontaktbrücke als auch über den Stromzähler erreicht wird.

Eine ähnliche Stromzähleranordnung ist auch aus der nicht vorveröffentlichten Schrift EP 1 462 808 A bekannt.

Bei der Ausführung nach der DE 10 2004 003 050.2 besitzt der Stromzähler an seiner Befestigungsfläche Füße, die beim Einsetzen auf jeweils eine zugehörige Stütze aufgesetzt werden; diese Stützen besitzen Schrägflächen, so dass im weiteren Verlauf der Montage der Stromzähler in den Adapter eingesenkt wird.

Es hat sich dabei herausgestellt, dass bei entsprechender sehr ungünstiger Handhabung der Stromzähler in eine Stellung, in der die Befestigungsfläche des Stromzählers einen spitzen Winkel mit der Befestigungsfläche am Adapter einnimmt, verschwenkt werden kann, die einen Anschlusskontaktstifte mit der zugehörigen Kontaktbrücke in Berührung gelangen können, so dass die anderen Anschlusskontaktstifte an Spannung gelegt sind; im ungünstigsten Falle passt die Hand einer Bedienperson dazwischen, so dass diese potentialführenden Anschlusskontaktstifte berührt werden können, so dass eine Gefährdung der Bedienperson gegeben sein kann.

Aufgabe der Erfindung ist es, die Stromzähleranordnung der eingangs genannten Art soweit weiter zu verbessern, dass auch in einem ungünstigen Fall eine Berührung spannungsführender Teile durch eine Bedienperson ausgeschlossen ist.

Diese Aufgabe wird erfindungsgemäß gelöst durch die Merkmale der Ansprüche 1 und 2.

Erfindungsgemäß also weisen die an der Befestigungsfläche angeordneten L-förmigen Füße am freien Ende jedes freien Schenkels der L-Form je eine senkrecht zur Befestigungsfläche verlaufende Anformung auf, die beim Aufsetzen der L-Form auf die Stützen die in Richtung einer Bewegung zur Endmontage des Stromzählers hingerichtete Stirnfläche der Stütze berührt und zumindest teilweise überdeckt, so dass ein Verschwenken des Stromzählers um eine Achse, die quer zur Bewegungsrichtung des Stromzählers verläuft, verhindert ist.

Dadurch, dass die An- oder Ausformung an der entsprechenden Kante oder Fläche der Stütze anlegt, ist ein Herausdrehen des Stromzählers um eine quer zur Stromführungsrichtung im Stromzähler aus dieser eine Vormontagestellung des Stromzählers einnehmenden Lage nicht mehr möglich, weil aufgrund der Verschwenkung die an der Stirnfläche der jeweiligen Stütze anliegende Kante am freien Ende der Anformung eine Kreisbewegung durchführen würde, die durch die entsprechende Stirnfläche der Stütze behindert ist.

Gemäß einer weiteren vorteilhaften Ausführungsform der Erfindung ist die Länge jeder Einführöffnung für die Füße in Bewegungsrichtung des Stromzählers genau auf die Länge des freien Schenkels der L-Form angepasst. Damit wird bei einer leichten Verschiebung des Stromzählers gegenüber dem Adapter das freie Ende des freien Schenkels der L-Form sofort hinter die benachbarte Kante der Einführöffnung gelangen, so dass ein Herausziehen nicht mehr möglich ist.

Gemäß einer weiteren vorteilhaften Ausgestaltung der Erfindung sind die zur Befestigungsfläche hinweisenden Kanten der freien Schenkel der L-Form etwa parallel zur Schrägfläche an den Stirnseiten der Stützen angeordnet.

Zusätzlich ist an jeder Einführöffnung die Wandstärke der Wandung des Adapters zur Einführöffnung hin verjüngt, wobei die Abschrägung etwa parallel zur zur Befestigungsfläche hinweisenden Kanten der freien Schenkel verläuft.

Gemäß einer weiteren Ausgestaltung der Erfindung kann an der Befestigungsseite des Stromzählers je ein senkrecht dazu verlaufender nasenartiger Vorsprung, auch Mitnehmer genannt, angeformt sein, der beim Aufsetzen des Stromzählers auf den Adapter in eine erste Aussparung an der Brücke eingreift; an der Brücke ist zusätzlich eine zweite Aussparung angebracht, in die der Anschlusssteckerstift am Stromzähler hineinragt, wobei der Anschlusssteckerstift und die zweite Aussparung so bemessen sind, dass beide dauernd frei voneinander bleiben, so dass beim Verbringen in die Endstellung und zurück lediglich der Vorsprung die Brücke verschiebt und eine elektrisch leitende Verbindung zwischen der Brücke und dem Anschlusssteckerstift verhindert ist.

Weitere vorteilhafte Ausgestaltungen der Erfindung sind den weiteren Unteransprüchen zu entnehmen.

Es bestehen insgesamt drei Möglichkeiten:
Der Stromzähler kann Füße aufweisen sowie einen Mitnehmer für die Kontaktbrücke jeder Phase, wobei die Füße lediglich L-förmig ausgebildet sind.

In einer Ausführungsform können die Füße mit der Anformung und der Stromzähler mit dem Mitnehmer versehen sein.

In einer Ausführungsform können Füße mit der Anformung eingesetzt werden, wobei der Mitnehmer am Stromzähler weggelassen ist.

Anhand der Zeichnungen, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen
- Fig. 1: eine perspektivische Ansicht einer Stromzähleranordnung, mit aufgeschnittenem Adapter,
- Fig. 2: eine Vergrößerung aus der Ansicht gemäß Fig. 1,
- Fig. 3: eine Aufsicht auf die Befestigungsseite des Stromzählers,
- Fig. 4: eine Teilansicht des Stromzählers gemäß Pfeilrichtung IV-IV und
- Fig. 5: eine Schnittansicht durch einen Stromzähler (dieser ist schematisch dargestellt) und den Adapter, wobei sich der Stromzähler in einer Vormontagestellung befindet.

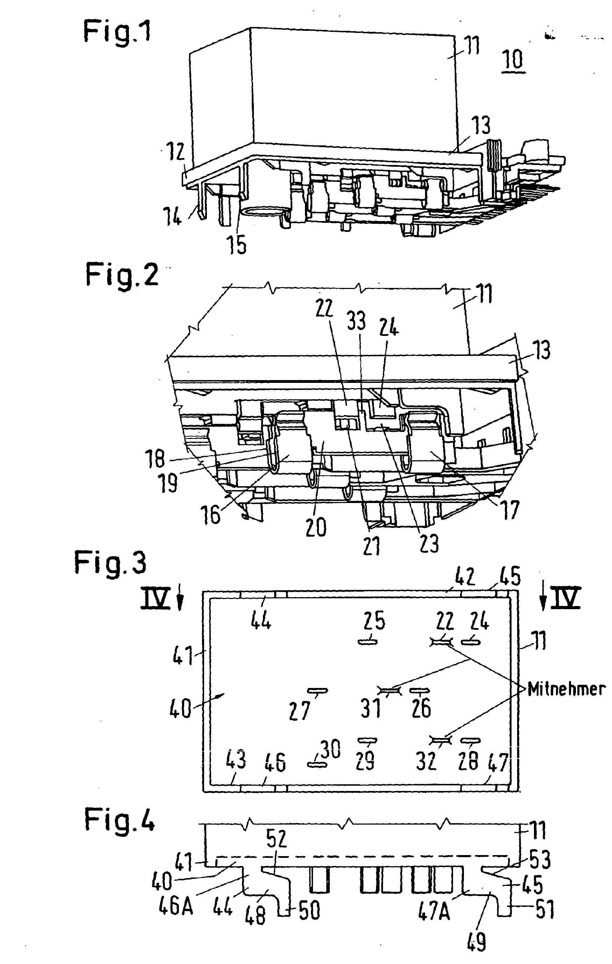

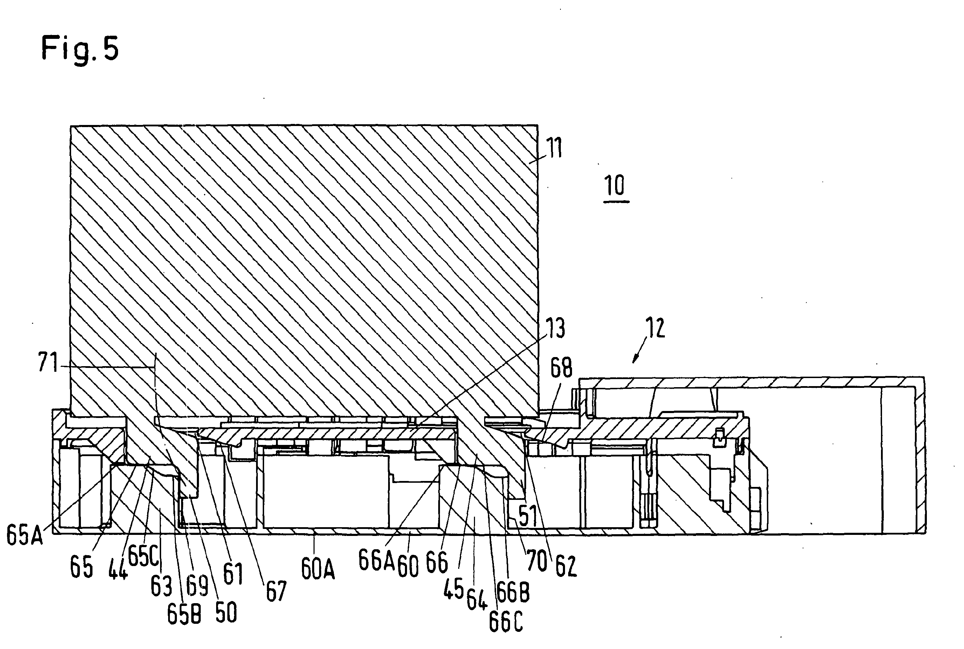

Die Stromzähleranordnung 10 gemäß Fig. 1 besitzt einen Stromzähler 11, der als elektronischer Stromzähler ausgebildet sein kann, und einen Adapter 12; von diesem Adapter 12 sind nur der Gehäusedeckel 13 mit daran angeformten Rastarmen 14 und 15 sowie einige Einbauten (siehe weiter unten) sichtbar. Von den Rastarmen 14 und 15 sind lediglich diejenigen an der einen Schmalstirnseite beziffert; der Deckel 13 besitzt noch weitere Rastarme, über die ein napfförmiges Gehäuseunterteil (siehe Fig. 5) am Deckel bzw. umgekehrt festgerastet werden kann. An der Innenfläche des Gehäuseunterteils sind feststehende Kontaktstücke 16, 17 für jede einzelne Phase fixiert (die anderen festen Kontaktstücke sind nur zum Teil sichtbar und ebenfalls nicht beziffert). Diese Kontaktstücke sind U-förmig ausgebildet, wobei die Schenkel 18 und 19 des Kontaktstückes 16 in einer Ebene mit den entsprechenden Schenkeln (nicht näher beziffert) des Kontaktstückes 17 liegen; die offenen Seiten der Kontaktstücke 16 und 17 sind zum Stromzähler 11 hin gerichtet. Innerhalb der jeweils zu einer Phase gehörenden Kontaktstücke 16 und 17 ist eine Brücke 20 angeordnet, die in Richtung der längeren Seitenflächen des Stromzählers bzw. der längeren Seitenkanten des Deckels 13 sowie in Richtung der Stromführung im Adapter 11 verschiebbar ist. Diese Brücke 20 ist aus langgestrecktem Flachbandleitermaterial hergestellt und besitzt an ihrer zum Stromzähler 11 hin weisenden Kante eine erste Aussparung 21, in die ein Mitnehmerzapfen 22, der an der Befestigungsfläche des Stromzählers 11 angeordnet ist und demgemäss aus isolierendem Material besteht, hineinpasst, wenn der Stromzähler auf den Adapter 12 aufgesetzt wird. Die Brücke 20 besitzt weiterhin eine zweite Aussparung 23, in die ein Anschlusssteckerstift 24 hineinragt bzw. eingreift, wenn der Stromzähler 11 montiert wird; die Abmessungen der zweiten Aussparung 23 sind dabei so wählen, dass der Anschlusssteckerstift 24, der auch als Anschlussfahne zu bezeichnen ist, in keinem Stadium der Montage in Berührung mit der Brücke 20 gelangt. Der Mitnehmerzapfen 22 ist auch als Vorsprung oder kurz Mitnehmer bezeichnet. Der Mitnehmer 22 ist somit formschlüssig mit der ersten Aussparung gekoppelt, wogegen zwischen der Anschlussfahne 24 und der Innenkontur der zweiten Aussparung 23 immer ein ausreichender isolierender Abstand eingehalten ist.

Eine entsprechende Ausführungsform ist auch für alle anderen Phasen gegeben.

Die Fig. 3 zeigt eine Aufsicht auf die Befestigungsfläche des Stromzählers 11 mit je zwei Anschlussfahnen 24, 25; beziehungsweise 26, 27 und 28, 29, wobei die in einer Linie liegenden Anschlussfahnen 24, 25; 26, 27; 28 und 29 jeweils einer Phase zugehörig sind. Die Linien verlaufen parallel zur längeren Seitenfläche des Stromzählers bzw. zur Längskante der Befestigungsfläche.

Zusätzlich ist eine Anschlussfahne 30 vorgesehen, die mit dem 0-bzw. Neutralleiterkontaktstück in Verbindung gelangt.

Jeder Phase zugehörig ist je ein Mitnehmer 22, 31 und 32, die jeweils auf der gleichen Linie liegen wie die Anschlussfahnen 24, 25; 26, 27; 28, 29 für jede Phase. Der Abstand des Mitnehmers 22 von der benachbarten Anschlussfahne 24 ist so bemessen, dass zwischen der ersten und zweiten Aussparung 21, 23 der Brücke 20 ein Zapfen 33 stehen bleibt, der so zu bemessen ist, dass er sich beim Verschieben der Brücke 20 durch den Mitnehmer 22 nicht verformt.

Die Fig. 4 zeigt die Ansicht gemäß Pfeilrichtung IV-IV des Stromzählers 11 im unteren Bereich, also im Bereich der Befestigungsfläche 40. Am Rand dieser Befestigungsfläche 40 ist eine umlaufende Leiste 41 vorgesehen, und an den längeren Leistenabschnitten 42 und 43 sind Füße 44, 45; 46, 47 angeformt, von denen in der Zeichnung Fig. 4 nur die Füße 44 und 45 sichtbar sind; die anderen Füße 46, 47 sind verdeckt. Jeder Fuß 44, 45; 46, 47 besitzt zunächst eine L-Form mit einem ersten Schenkel 46A, 47A, der senkrecht zur Leiste 41 bzw. Befestigungsfläche 40 verläuft, an dem je ein zweiter Schenkel 48 bzw. 49, der im wesentlichen parallel zur Befestigungsfläche 40 verläuft, anschließen, wobei die Schenkel 48 und 49 in gleiche Richtung, d.h. in Richtung der Endmontagestellung vorspringen. An den freien Enden der Schenkel 48, 49 schließen sich Anformungen 50 und 51 an, die senkrecht zu den Schenkeln 48 und 49 und senkrecht zur Befestigungsfläche 40 verlaufen. Die zur Befestigungsfläche 40 hinweisenden Kanten 52 und 53 der Schenkel 48, 49 bilden einen spitzen Winkel mit der Befestigungsfläche bzw. mit der freien Kante der Leiste 41.

Es sei nun Bezug genommen auf die Fig. 5.

Die Stromzähleranordnung setzt sich zusammen aus dem Stromzähler 11 und dem Adapter 12, wobei der Adapter 12 ein Gehäuseunterteil 60 aufweist, welches napfförmig ist und mit dem Deckel 13 über die Rastarme 14 und 15 verrastet werden kann.

Der Deckel 13 besitzt schlitzartige Durchstecköffnungen 61 und 62 für jeden Fuß 44, 45; 46, 47; in der Darstellung gemäß Fig. 5 dienen die Öffnungen 61 und 62 zum Einführen der Füße 44 und 45. Die Länge der Einführungsöffnungen 61 und 62 entspricht der Länge der Schenkel 48, 49. Die Durchstecköffnungen für die Füße 46, 47 sind in Fig. 5 verdeckt, besitzen aber die gleiche Form wie die für die Füße 44, 45.

Auf der Innenfläche des Gehäuseunterteils ist eine der Anzahl der Füße entsprechende Anzahl (hier vier) von Stützen 63, 64 angeformt, die den Stützen 28, 50a, 50b der DE 10 2004 003 050.2 entsprechen. Die Stirnseiten 65 und 66 sind ebenso ausgebildet wie die Stirnseiten der genannten Stützen in der DE 10 2004 003 050.2. Die Stirnseiten 65 und 66 besitzen zwei Abschnitte 65a und 65b bzw. 66a und 66b, von denen die Abschnitte 65A und 66A einen größeren Abstand von der Innenfläche des Bodens 60A des Gehäuseunterteils 60 als die Abschnitte 65B, 66B einnehmen; zwischen den Abschnitten 65a, 65b bzw. 66a, 66b befindet sich je ein schrägverlaufender Abschnitt 65c und 66c, die die beiden Abschnitte 65a, 65b; 66a, 66b miteinander verbinden. Die Abschnitte 65c und 66c bilden mit der Innenfläche des Bodens 60a einen spitzen Winkel, wobei die Abschnitte 65c und 66c etwa parallel zu den Kanten 52, 53 der Schenkel 48, 49 verlaufen. Die Abschnitte 65B, 66B liegen bezogen auf die Abschnitte 65A, 66A in Richtung hin zur Endmontagestellung. Die Stirnseiten der Stützen können natürlich auch so ausgebildet sein wie in den Figuren 6 bis 8 der DE 10 2004 003 050.2 dargestellt.

Die Montage des Stromzählers 11 geschieht wie folgt:

Zunächst wird der Stromzähler 11 senkrecht zu seiner Befestigungsfläche auf den Adapter aufgesetzt, wobei die Füße 44, 45; 46, 47 durch die als Schlitze ausgebildeten Öffnungen 61, 62 hindurch gesteckt werden, solange, bis sich die Außenkanten der Schenkel 48, 49 auf den Abschnitt 65a bzw. 66a jeder Stütze aufsetzt. Sodann wird der Stromzähler 11 derart weiterbewegt, dass die Füße 44, 45; 46, 47 auf den Abschnitten 65a, 65c bzw. 66a, 66c gleiten und dadurch der Stromzähler 11 senkrecht zu seiner Befestigungsfläche abgesenkt und damit in Endmontagestellung verbracht wird. Die Wandstärke des Deckels verjüngt sich im Bereich der Schlitze 61 und 62 auf diese zu und in diese einmündend, wodurch eine Schrägfläche 67 bzw. 68 gebildet ist, die parallel zu der Kante 52 bzw. 53 verläuft, so dass beim Einschieben und Absenken des Stromzählers 11 die Kanten 52, 53 an den schrägen Flächen 67, 68 entlang gleiten und so den Deckel 13 hintergreifen und auch nach unten geführt werden.

In der in der Fig. 5 gezeigten Vormontagestellung liegen die Ausformungen 50 und 51 an der senkrecht zur Innenfläche des Gehäusebodens 60A verlaufenden und zur Endmontagestellung hinweisenden Stirnflächen 69, 70 an, so dass in der Vormontagestellung eine Schwenkung um eine senkrecht zur Zeichenebene verlaufende Achse, die sich z. B. im Bereich der Füße 45, 47 befindet, verhindert wird, weil die Ausformung 50 gegen die Stirnfläche 69 anliegt. Wenn sich die Ausformung 50 beispielsweise auf einer Kreisbahn 71 bewegen sollte, dann behindert die Stirnfläche 69 den Fuß bzw. die Ausformung 50, wie aus der Zeichnung Fig. 5 klar ersichtlich ist und was natürlich auch für die Ausformung am Fuß 46 gilt.

Beim Absenken des Stromzählers 11 und danach beim Abgleiten auf den Abschnitten 65C und 66C gelangen die Mitnehmer 22, 31, 32 in ihre zugehörigen Aussparungen 21 jeder Brücke und verschieben dabei diese Brücken dergestalt, dass die Anschlussfahnen 24, 25; 26, 27; 28, 29 in die zugehörigen feststehenden Kontaktstücke 16, 17 einlaufen und mit diesen in elektrisch leitende Berührung gelangen, bevor die Brücken 20 frei von den Kontaktstücken 16 durch einfaches Herausziehen aus den Kontaktstücken 16 und die Kontaktstücke 17 in den Bereich der zweiten Aussparungen 23 gelangen, wodurch eine elektrisch leitende Verbindung zwischen den Kontaktstücken 16 und 17 über die Brücken 20 und eine elektrisch leitende Verbindung von den Kontaktstücken 16, 17 zu den zugehörigen Anschlussfahnen 24, 25 erreicht ist, so dass in diesem Zeitbereich der Strom sowohl über den Stromzähler 11 als auch über die Brücken 20 fließt. Sobald der Stromzähler 11 in seine Endstellung gelangt, ist die dargestellte Brücke 20 mit einem Ende frei vom Kontaktstück 16 und das Kontaktstück 17 befindet sich im Bereich der Aussparung 23, so dass eine elektrisch leitende Verbindung zwischen den Kontaktstücken 16, 17 über die Brücke 20 nicht mehr gegeben ist. Das gleiche gilt selbstverständlich auch für alle anderen Phasen, weil auch dort entsprechend ausgebildete Kontaktstücke und Brücken vorgesehen sind.

Die Demontage erfolgt dann so, dass der Stromzähler in die in Fig. 5 gezeigte Vormontagestellung verbracht wird, wobei die Füße auf den Schrägflächen 65C, 66C aufgleiten, wodurch über den Mitnehmer 27 die Brücke 20 verschoben wird; die Brücke 20 überbrückt während der Anhebebewegung des Stromzählers 11 die Kontakte 16, bevor die Anschlussfahnen 24, 25 frei von den Kontaktstücken 16, 17 kommen, was auch für die anderen Phasen gilt.

In dem Fall, wenn die Anschlussfahnen 25, 24 noch in elektrisch leitende Verbindung mit den Kontaktstücken 16 und 17 stehen bzw. gerade erst in elektrisch leitende Berührung gelangt sind, fließt der Strom sowohl über die Brücke 20 als auch durch den Stromzähler 11 hindurch.

Es sind bei der Ausgestaltung der Anordnung gemäß Fig. 1 außer der in den Zeichnungen dargestellten Ausführungsform noch weitere Ausführungen denkbar. Beispielsweise könnten bei der Ausführung mit den Füßen 44, 45 mit Ausformungen 50, 51 die Mitnehmer entfallen, so dass die zweite Aussparung 23 betreffend Abmessungen der ersten Aussparung 21 entspricht, so dass die Kontaktfahnen 24 genau in diese Aussparungen hineinpassen. In diesem Falle wäre die Aussparung 21 nicht erforderlich.

Eine weitere Ausführungsform könnte dahin gehen, dass die Ausformungen 50, 51 wegfallen; in diesem Falle wären die Mitnehmer 22, 31, 32 vorhanden und demgemäss auch die erste und zweite Aussparung 20, 23 an jeder Brücke 20.

## Patentansprüche

1. Stromzähleranordnung (10) mit einem in einem Zählerschrank befestigbaren Adapter (12) und einem Stromzähler (11), der auf den Adapter aufsetzbar ist, mit im Adapter untergebrachten, ein Paar pro Phase bildenden Kontaktstücken (15, 16), von denen je eines mit je einem Stromzuführungsleiter und das andere mit einem Stromabführungsleiter verbunden ist, mit aus der Befestigungsfläche des Stromzähler (11) herausragenden Anschlusssteckerstiften (24, 25; 26, 27; 28, 29), insbesondere Anschlussfahnen, mit einer Kontaktbrücke (20) für jede Phase, die die feststehenden Kontaktstücke (15, 16) jeweils einer Phase bei demontiertem Stromzähler (11) überbrückt, und mit an der Befestigungsfläche (40) des Stromzählers befindlichen L-förmigen Füßen (44, 45; 46, 47), die bei der Montage und Demontage des Stromzählers auf je einer Gleitfläche (65, 66) im Adapter (12) gleiten, wobei am freien Ende der freien Schenkel (48, 49) jeder L-Form der L-förmigen Füße je eine senkrecht zur Befestigungsfläche (40) verlaufende Ausformung (50, 51) angeformt ist, die beim Aufsetzen der L-Form auf die zugehörige Gleitfläche (65, 66) je einer Stütze derart angeordnet ist, dass sie die in Richtung einer Endmontierbewegung des Stromzählers (11) hinweisende und senkrecht zur Befestigungsfläche des Adapters (11) verlaufende Stimfläche (69, 70) jeder Stütze berührt und zumindest teilweise überdeckt, so dass ein Verschwenken des Stromzählers (11) um eine Achse, die quer zur Bewegungsrichtung des Stromzählers (11) verläuft, zumindest behindert ist.

2. Stromzähleranordnung (10) mit einem in einem Zählerschrank befestigbaren Adapter (12) und einem Stromzähler (11), der auf den Adapter aufsetzbar ist, mit im Adapter untergebrachten, ein Paar pro Phase bildenden Kontaktstücken (15, 16), von denen je eines mit je einem Stromzuführungsleiter und das andere mit einem Stromabführungsleiter verbunden ist, mit aus der Befestigungsfläche des Stromzähler (11) herausragenden Anschlusssteckerstiften (24, 25; 26, 27; 28, 29), insbesondere Anschlussfahnen, mit einer Kontaktbrücke (20) für jede Phase, die die feststehenden Kontaktstücke (15, 16) jeweils einer Phase bei demontiertem Stromzähler (11) überbrückt, und mit an der Befestigungsfläche (40) des Stromzählers befindlichen L-förmigen Füßen (44, 45; 46, 47), die bei der Montage und Demontage des Stromzählers auf je einer Gleitfläche (65 66) im Adapter (12) gleiten, wobei an der Befestigungsfläche (40) des Gehäuses des Stromzählers (11) pro Phase je ein senkrecht dazu verlaufender nasenartiger Vorsprung (Mitnehmerzapfen) (22, 31, 32) angeformt ist, der beim Aufsetzen des Stromzählers (11) auf den Adapter (12) in eine erste Aussparung (21) an jeder Kontaktbrücke (20) eingreift, und dass an der Kontaktbrücke (20) eine zweite Aussparung (23) angebracht ist, in die der benachbarte Anschlusssteckerstift (24, 26, 28) hineinragt, wobei der Anschlusssteckerstift und die zweite Aussparung so bemessen sind, dass beide dauernd frei voneinander bleiben, so dass beim Verbringen des Stromzählers in seine Endstellung und zurück lediglich der Vorsprung bzw. Mitnehmerzapfen (22, 31, 32) mit der Kontaktbrücke (20) für jede Phase formschlüssig verbunden ist.

3. Stromzähleranordnung nach dem Anspruch 1, wobei an der Befestigungsfläche (40) des Gehäuses des Stromzählers (11) pro Phase je ein senkrecht dazu verlaufender nasenartiger Vorsprung (Mitnehmerzapfen) (22, 31, 32) angeformt ist, der beim Aufsetzen des Stromzählers (11) auf den Adapter (12) in eine erste Aussparung (21) an jeder Kontaktbrücke (20) eingreift, und dass an der Kontaktbrücke (20) eine zweite Aussparung (23) angebracht ist, in die der benachbarte Anschlusssteckerstift (24, 26, 28) hineinragt, wobei der Anschlusssteckerstift und die zweite Aussparung so bemessen sind, dass beide dauernd frei voneinander bleiben, so dass beim Verbringen des Stromzählers in seine Endstellung und zurück lediglich der Vorsprung bzw. Mitnehmerzapfen (22, 31, 32) mit der Kontaktbrücke (20) für jede Phase formschlüssig verbunden ist.

4. Stromzähleranordnung nach einem der vorherigen Ansprüche 4, wobei die Einführöffnungen (61, 62) für die L-förmigen Füße (44, 45) in Bewegungrichtung des Stromzählers gemessen genau auf die Länge des freien Schenkels der L-Form jedes Fußes angepasst sind.

5. Stromzähleranordnung nach einem der vorherigen Ansprüche 5, wobei die zur Befestigungsfläche des Stromzählers hinweisenden Kanten der freien Schenkel der L-Form etwa parallel zur Schrägfläche an den Stirnseiten der Stützen verlaufen.

6. Stromzähleranordnung nach einem der vorherigen Ansprüche 6, wobei an jeder Einführöffnung die Wandstärke der Wandung des Adapterdeckels zur Einführöffnung hin kleiner wird, wobei die Abschrägung etwa parallel zu der zur Befestigungsfläche hinweisenden Kante der freien Schenkel der Füße bzw. zu den Schrägflächen an den Stützen verlaufen.

## Claims

1. An electricity meter arrangement (10), comprising an adapter (12) fastenable in a meter cabinet and an electricity meter (11) which can be placed on the adapter, with contact elements (15, 16) which are housed in the adapter, form a pair per phase and of which one each is connected to a power supply lead and the other to a power lead-away lead, with terminal plug pins (24, 25; 26, 27; 28, 29) projecting from the fastening surface of the electricity meter (11), especially terminal lugs, with a contact bridge (20) for each phase which bridges the fixed contact elements (15, 16) with a phase each when the electricity meter (11) is dismounted, and with L-shaped feet (44, 45; 46, 47) which are situated on the fastening surface (40) of the electricity meter and which during the mounting and dismounting of the electricity meter slide on a slide surface (65, 66) each in the adapter (12), wherein a shaped part (50, 51) is each formed on the free end of the free leg (48, 49) of each L-form of the L-shaped feet, which shaped part extends perpendicular to the fastening surface (40) and is arranged on a support each on the placement of the L-form on the associated slide surface (65, 66) in such a way that it touches the face surface (69, 70) of each support, which face surface indicates the direction of the final mounting movement of the electricity meter (11) and extends perpendicular to the fastening surface of the adapter (11) and at least partly covers the same, so that a swiveling of the electricity meter (11) about an axis extending transversally to the direction of movement of the electricity meter (11) is at least obstructed.

2. An electricity meter arrangement (10), comprising an adapter (12) fastenable in a meter cabinet and an electricity meter (11) which can be placed on the adapter, with contact elements (15, 16) which are housed in the adapter, form a pair per phase and of which one each is connected to a power supply lead and the other to a power lead-away lead, with terminal plug pins (24, 25; 26, 27; 28, 29) projecting from the fastening surface of the electricity meter (11), especially terminal lugs, with a contact bridge (20) for each phase which bridges the fixed contact elements (15, 16) with a phase each when the electricity meter (11) is dismounted, and with L-shaped feet (44, 45; 46, 47) which are situated on the fastening surface (40) of the electricity meter and which during the mounting and dismounting of the electricity meter slide on a slide surface (65, 66) each in the adapter (12), wherein a nose-like projection (driver pin) (22, 31, 32) is each formed on the fastening surface (40) of the housing of the electricity meter (11) per phase, which projection extends perpendicular thereto and which upon placement of the electricity meter (11) on the adapter (12) engages in a first recess (21) on each contact bridge (20), and that a second recess (23) is provided in the contact bridge (20), into which projects the adjacent terminal plug pin (24, 26, 28), with the terminal plug pin and the second recess being dimensioned in such a way that both remain permanently free from each other, so that during the displacement of the electricity meter to its end position and back only the projection or driver pin (22, 31, 32) is connected in a positive-locking manner with the contact bridge (20) for each phase.

3. An electricity meter arrangement according to claim 1, wherein a nose-like projection (driver pin) (22, 31, 32) is each formed on the fastening surface (40) of the housing of the electricity meter (11) per phase, which projection extends perpendicular thereto and which upon placement of the electricity meter (11) on the adapter (12) engages in a first recess (21) on each contact bridge (20), and that a second recess (23) is provided in the contact bridge (20), into which projects the adjacent terminal plug pin (24, 26, 28), with the terminal plug pin and the second recess being dimensioned in such a way that both remain permanently free from each other, so that during the displacement of the electricity meter to its end position and back only the projection or driver pin (22, 31, 32) is connected in a positive-locking manner with the contact bridge (20) for each phase.

4. An electricity meter arrangement according to one of the preceding claims, wherein the insertion opening (61, 62) for the L-shaped feet (44, 45), as measured precisely in the direction of movement of the electricity meter, are adjusted precisely to the length of the free legs of the L-shape of each foot.

5. An electricity meter arrangement according to one of the preceding claims, wherein the edges of the free legs of the L-shape facing the fastening surface of the electricity meter extend approximately parallel to the inclined surface on the face sides of the supports.

6. An electricity meter arrangement according to one of the preceding claims, wherein the wall thickness of the wall of the adapter cover to the insertion opening becomes smaller at each insertion opening, with the beveling extending approximately parallel to the edge of the free legs of the feet facing to the fastening surface or to the inclined surfaces on the supports.

## Revendications

1. Dispositif de compteur électrique (10) avec un adaptateur (12) pouvant être fixé dans une armoire de compteur et avec un compteur électrique (11) pouvant être posé sur l'adaptateur, avec une paire de contacts (15, 16) disposés dans l'adaptateur et formant une paire par phase, dont l'un est relié à un conducteur d'entrée de courant et l'autre à un conducteur de sortie de courant, avec des broches de connecteur (24, 25 ; 26, 27 ; 28, 29) dépassant de la surface de fixation du compteur électrique (11), en particulier des barrettes de connexion, avec un pont de contact (20) pour chaque phase, qui shunte les contacts fixes (15, 16) de chaque phase lorsque le compteur électrique (11) est démonté, et avec des pieds en forme de L (44, 45 ; 46, 47) situés sur la surface de fixation (40) du compteur électrique, qui glissent chacun sur une surface de glissement (65, 66) de l'adaptateur (12) lors du montage et du démontage du compteur électrique, dans lequel il est prévu formé sur l'extrémité libre des bras libres (48, 49) de chaque L des pieds en forme de L un relief (50, 51) perpendiculaire à la surface de fixation (40), qui est disposé lors de la pose du L sur la surface de glissement (65, 66) de chaque appui, de façon à toucher et à recouvrir au moins partiellement la face d'extrémité (69, 70) de chaque appui orientée en direction d'un mouvement de montage final du compteur électrique (11) et perpendiculairement à la surface de fixation de l'adaptateur (11), de sorte qu'un basculement du compteur électrique (11) autour d'un axe perpendiculaire au sens de déplacement du compteur électrique (11) est au minimum gêné.

2. Dispositif de compteur électrique (10) avec un adaptateur (12) pouvant être fixé dans une armoire de compteur et avec un compteur électrique (11) pouvant être posé sur l'adaptateur, avec une paire de contacts (15, 16) disposés dans l'adaptateur et formant une paire par phase, dont l'un est relié à un conducteur d'entrée de courant et l'autre à un conducteur de sortie de courant, avec des broches de connecteur (24, 25 ; 26, 27 ; 28, 29) dépassant de la surface de fixation du compteur électrique (11), en particulier des barrettes de connexion, avec un pont de contact (20) pour chaque phase, qui shunte les contacts fixes (15, 16) de chaque phase lorsque le compteur électrique (11) est démonté, et avec des pieds en forme de L (44, 45 ; 46, 47) situés sur la surface de fixation (40) du compteur électrique, qui glissent chacun sur une surface de glissement (65, 66) de l'adaptateur (12) lors du montage et du démontage du compteur électrique, dans lequel il est prévu formé sur la surface de fixation (40) du boîtier du compteur électrique (11) pour chaque phase une saillie en forme d'ergot (goujon d'entraînement) (22, 31, 32) perpendiculaire à celle-ci, qui se met en prise lors de la pose du compteur électrique (11) sur l'adaptateur (12) dans une première ouverture (21) de chaque pont de contact (20), et dans lequel il est prévu sur le pont de contact (20) une deuxième ouverture (23) dans laquelle dépasse la broche de connecteur (24, 26, 28) voisine, la broche de connecteur et la deuxième ouverture étant dimensionnées de telle sorte que toutes deux restent durablement à l'écart l'une de l'autre, de sorte que lorsque le compteur électrique est amené dans sa position finale et retour, seule la saillie ou le goujon d'entraînement (22, 31, 32) est en prise par engagement positif avec le pont de contact (20) pour chaque phase.

3. Dispositif de compteur électrique selon la revendication 1, dans lequel dans lequel il est prévu formé sur la surface de fixation (40) du boîtier du compteur électrique (11) pour chaque phase une saillie en forme d'ergot (goujon d'entraînement) (22, 31, 32) perpendiculaire à celle-ci, qui se met en prise lors de la pose du compteur électrique (11) sur l'adaptateur (12) dans une première ouverture (21) de chaque pont de contact (20), et dans lequel il est prévu sur le pont de contact (20) une deuxième ouverture (23) dans laquelle dépasse la broche de connecteur (24, 26, 28) voisine, la broche de connecteur et la deuxième ouverture étant dimensionnées de telle sorte que toutes deux restent durablement à l'écart l'une de l'autre, de sorte que lorsque le compteur électrique est amené dans sa position finale et retour, seule la saillie ou le goujon d'entraînement (22, 31, 32) est en prise par engagement positif avec le pont de contact (20) pour chaque phase.

4. Dispositif de compteur électrique selon l'une quelconque des revendications précédentes, dans lequel les ouvertures d'insertion (61, 62) destinées aux pieds en forme de L (44, 45) ont une dimension dans le sens de déplacement du compteur électrique exactement adaptée à la longueur du bras libre du L de chaque pied.

5. Dispositif de compteur électrique selon l'une quelconque des revendications précédentes, dans lequel les bords des bras libre du L tournés vers la surface de fixation du compteur électrique sont approximativement parallèles à la surface oblique sur les faces d'extrémité des appuis.

6. Dispositif de compteur électrique selon l'une quelconque des revendications précédentes, dans lequel, au niveau de chaque ouverture d'introduction, l'épaisseur de la paroi du couvercle de l'adaptateur diminue en direction de l'ouverture d'introduction, le chanfrein étant approximativement parallèle au bord du bras libre des pieds tournés vers la surface de fixation ou aux surfaces obliques des appuis.
